# EUROPEAN PATENT APPLICATION

(11) **EP 2 006 899 A2**
(43) Date of publication of application: **24.12.2008**
(21) Application number: 07739871.7
(22) Date of filing: 27.03.2007
(51) Int. Cl.: H01L 21/68, G03F 7/20, H01L 21/027

(54) **STAGE APPARATUS, EXPOSURE APPARATUS, STAGE CONTROL METHOD, EXPOSURE METHOD AND DEVICE MANUFACTURING METHOD**

(30) Priority: 05.04.2006 JP 2006103860
(71) Applicant: Nikon Corporation, Tokyo 100-8331 (JP)
(72) Inventor: KUMAZAKI, Kiyoaki, Tokyo 100-8331 (JP)
(74) Representative: Hooiveld, Arjen Jan Winfried
(86) International application number: PCT/JP2007/056433
(87) International publication number: WO 2007/116752

(57) **Abstract**

A stage apparatus includes a mover having a holding part that holds a substrate, and a first mechanism and a control apparatus. The mover is capable of moving between a first position and a second position. At the first position, the substrate is held by the holding part, and, at the second position, the substrate is released from the holding part. The first mechanism can adjust a gap between the substrate and the holding part. The control apparatus simultaneously executes the movement of the mover between the first position and the second position, and with the adjustment of the gap by the first mechanism.

## Description

### TECHNICAL FIELD

The present invention relates to a stage apparatus, an exposure apparatus, a stage control method, an exposure method, and a device fabricating method.

Priority is claimed on Japanese Patent Application No. 2006-103860, filed April 5, 2006, the contents of which are incorporated herein by reference.

### BACKGROUND ART

Conventionally, in an exposure apparatus for exposing a substrate such as a wafer or a glass plate, a stage apparatus is provided that is capable of moving within a two-dimensional plane while holding the substrate.

In this case, the stage apparatus includes a stage body that is configured to be capable of moving within a horizontal plane (two-dimensional plane), and a table part that is disposed above the stage body and is capable of moving vertically. When loading the substrate to the stage apparatus and unloading the substrate from the stage apparatus, the table part moves vertically above the stage body.

When driving the stage body within the two-dimensional plane, the table part is previously lowered down. The table part remains in the lowered state, when the stage body moves in the two-dimensional plane. Thereby, for example, a substrate is moved to a predetermined exposed position, or an exposed substrate is moved to an exchanging position (e.g., refer to Patent Document 1).

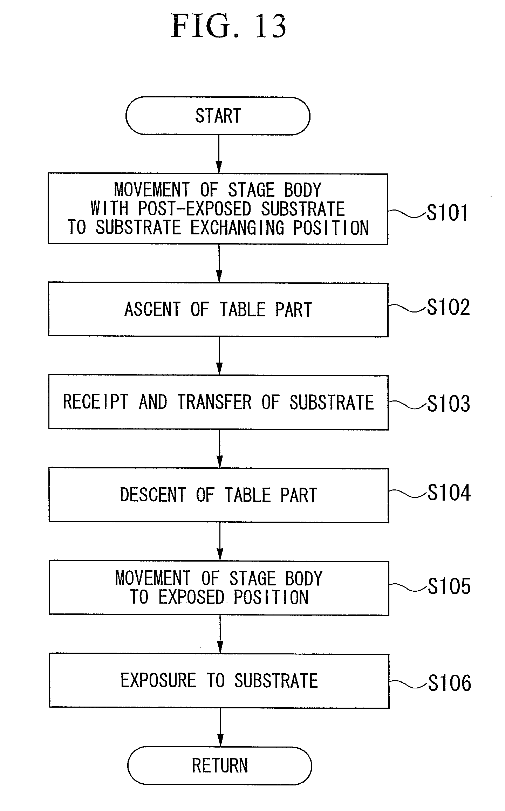

FIG. 13 is a flowchart showing movement of a stage along with the exchange of a substrate, according to prior art. As shown in FIG. 13, in the substrate exchange, at first, a stage body on which an exposed substrate is mounted moves to a substrate exchanging position (step S101). Then, a table part above the stage body is lifted up (step S102). Next, the exposed substrate is unloaded from the table part, which has been lifted up, toward a loader, and a non-exposed substrate is loaded into (step S103). Next, a table part is lowered down (step S104). Thereafter, the stage body moves to an exposed position (step S 105). Next, the substrate is exposed (step S 106). After that, returning to step S101, the stage body moves to the substrate exchanging position (step S101).
[Patent Document 1] Japanese Patent Application Publication No. H06-163357 A

### DISCLOSURE OF INVENTION

### PROBLEMS TO BE SOLVED BY THE INVENTION

In recent years, an increase in throughput (the number of substrates that are processed per unit of time) is demanded. The shortening of the substrate exchange time leads to an increase in throughput.

A purpose of the present invention is to provide a method in which the substrate exchange time can be shortened.

### MEANS FOR SOLVING THE PROBLEM

The present invention adopts the following configurations that correspond to the drawings, which describe the embodiments. However, any parenthesized symbol appended to an element is merely for the purpose of illustration and that element is not limited thereby

According to a first aspect of the invention, there is provided a stage apparatus, wherein the stage apparatus comprises: a mover (11) movable between a first position (P1) and a second position (P2) and having a holding part (15) that holds a substrate (W), the substrate (W) being held by the holding part (15) at the first position (P1) and being released from the holding part (15) at the second position (P2); a first mechanism (12) that adjusts a gap between the substrate (W) and the holding part (15); and a control apparatus (3) that simultaneously executes the movement of the mover (11) between the first position (P1) and the second position (P2) and at least a part of the adjustment of the gap by the first mechanism (12).

According to a second aspect of the invention, there is provided an exposure apparatus (A), wherein the exposure apparatus positions a substrate (W) at an exposed position by use of the stage apparatus described above, and that executes an exposure process to the substrate (W) at the exposed position.

According to a third aspect of the invention, there is provided a stage control method, wherein the method comprises: moving a substrate (W) between a first position (P1) and a second position (P2), the substrate (W) being held by a holding part (15) at the first position (P1) and being released from the holding part (15) at the second position (P2); and adjusting a gap between the substrate (W) and the holding part (15), at least a part of the adjustment being executed along with the movement of the substrate (W).

According to a fourth aspect of the invention, there is provided an exposure method, wherein the method comprises: controlling a stage by use of the stage control method according to the aspect described above; and positioning the substrate (W) at an exposed position and executing an exposure process to the substrate (W) at the exposed position.

According to a fifth aspect of the invention, there is provided a device fabricating method, wherein the method comprises a control step in which a stage is controlled by use of the stage control method according to the above described aspect.

According to a sixth aspect of the invention, there is provided a stage apparatus, wherein the stage apparatus comprises: a mover (11) movable between a first position (P1) and a second position (P2) and having a holding part (15) that holds a substrate (W), the substrate (W) being held by the holding part (15) at the first position (P1) and being released from the holding part (15) at the second position (P2); and a second mechanism (11b) that supplies a gas toward the substrate (W), the supply of the gas being executed along with at least a part of the movement of the mover (11) between the first position (P1) and the second position (P2).

According to a seventh aspect of the invention, there is provided a stage control method, wherein the method comprises: moving a substrate (W) between a first position (P1) and a second position (P2), the substrate (W) being held by a holding part (15) at the first position (P1) and being released form the holding part (15) at the second position (P2); supplying a gas toward the substrate (W), wherein at least a part of the supply of the gas is executed along with the movement of the substrate (W).

### EFFECTS OF THE INVENTION

According to the invention, an increase in throughput (the number of substrates that are processed per unit of time) can be attained.

### BRIEF DESCRIPTION OF THE DRAWINGS

FIG. 1 is a schematic block diagram showing an exposure apparatus.
FIG. 2 is a plane view for explaining a stage apparatus and a loader.
FIG. 3 is a plane view showing the stage apparatus.
FIG. 4 is an explanatory drawing showing a case in which a wafer is transferred from the loader to the center pins at a wafer exchanging position.
FIG. 5 is an explanatory drawing showing a case in which the wafer is moved to an exposure processing position by use of the stage apparatus.
FIG. 6A is an explanatory drawing showing a case in which the wafer is moved to the exposure processing position by use of the stage apparatus.
FIG. 6B is an explanatory drawing showing a case in which the wafer is moved to the exposure processing position by use of the stage apparatus.
FIG. 6C is an explanatory drawing showing a case in which the wafer is moved to the exposure processing position by use of the stage apparatus.
FIG. 7 is an explanatory drawing showing a case in which the wafer is exposed at the exposure processing position.
FIG. 8 is an explanatory drawing showing a case in which the wafer is moved to the wafer exchanging position by use of the stage apparatus.
FIG. 9A is an explanatory drawing showing a case in which the wafer is moved to the wafer exchanging position by use of the stage apparatus.
FIG. 9B is an explanatory drawing showing a case in which the wafer is moved to the wafer exchanging position by use of the stage apparatus.
FIG. 9C is an explanatory drawing showing a case in which the wafer is moved to the wafer exchanging position by use of the stage apparatus.
FIG. 10 is an explanatory drawing showing a case in which the wafer is transferred from the center pins to the loader at the wafer exchanging position.
FIG. 11 is a flowchart showing a movement of the substrate by use of the stage apparatus and the loader.
FIG. 12 is a flowchart showing an example of a semiconductor device manufacturing process.
FIG. 13 is a flowchart showing movement of a stage, according to prior art.

### DESCRIPTION OF THE REFERENCE SYMBOLS

A: exposure apparatus, W: wafer, S: region, P1: wafer exchanging position, P2: exposure processing position, P3: checking position, 1: stage apparatus, 3: CPU, 11: stage body, 11a: suction port, 11b: air supply port, 12: center pin, 13: loader, 15: wafer holder

### BEST MODE FOR CARRYING OUT THE INVENTION

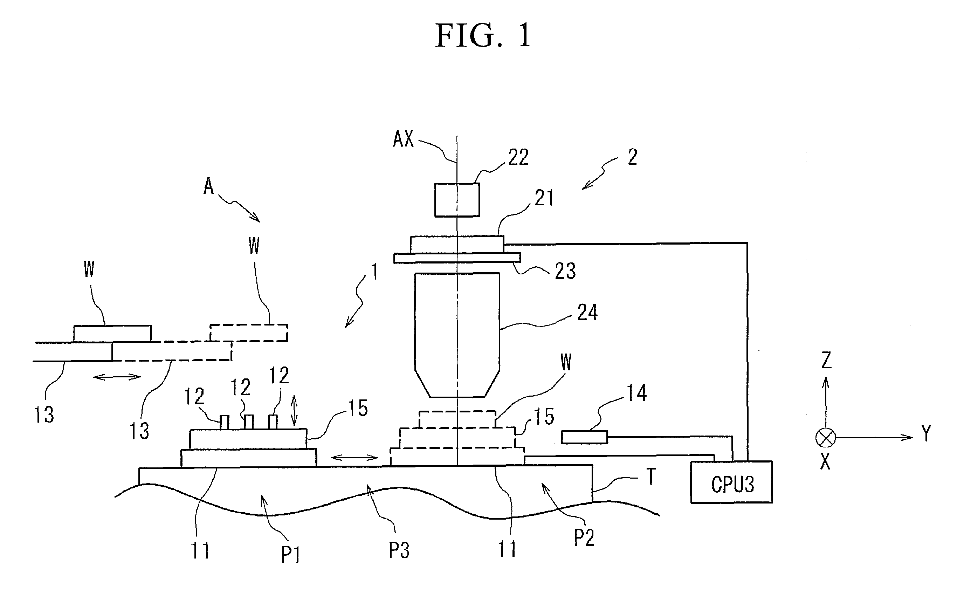

Hereunder is a description of embodiments of the present invention, with reference to the drawings. FIG. 1 is a schematic block diagram showing an exposure apparatus A that exposes a wafer, which is used in a fabricating process of a microdevice such as a semiconductor device. The exposure apparatus A projects a predetermined pattern to a wafer W for exposure, according to a control signal from a CPU 3. By means of a loader 13 and a stage apparatus 1, the wafer W is moved, from a wafer housing part (not shown) of Front Open Unified Pod (FOUP) and the like, which is disposed nearby, toward an exposure processing position P2. Furthermore, the wafer W is exposed by use of an optical system 2.

First, the optical system 2 will be explained. As shown in FIG. 1, the optical system 2 comprises: a reticle stage 23 that holds a reticle 21 on which a reticle pattern served as a transferred pattern is formed; an illumination system 22 that has an excimer laser and the like and illuminates the reticle 21; and a projection lens 24 via which the reduced image of the reticle pattern is projected onto the substrate.

In FIGS. 1 to 10, the direction along an optical axis AX of the projection lens 24 is the Z axis direction, the right-and-left direction in FIG. 1 is Y axis direction, and the direction orthogonal to the sheet plane in FIG. 1 is the X axis direction.

The reticle stage 23 can suction and hold the reticle 21 by, for example, vacuum chucking or electrostatic chucking.

The positional information of the reticle stage 23 in the XY plane is detected by a position detecting system such as an interferometer (not shown). The control signal from the CPU 3 is provided based on the detected positional information of the reticle stage 23. The reticle stage 23 is driven by, for example, a motor (not shown), and is capable of moving within the XY plane, which is orthogonal to an optical axis of the illumination system 22 (corresponding the optical axis AX of the projection lens 24).

The projection lens 24 comprises a dioptric system having a reduction magnification (e.g., 1/4 or 1/5). The illumination light (exposure light) having been transmitted through the reticle 21 is, via the projection lens 24, irradiated onto a wafer W, which is suctioned and held by a wafer holder 15 discussed later. As a result, the reduced image of the pattern of the reticle 21 is transferred onto the wafer W.

Next, the stage apparatus 1 will be explained. The stage apparatus 1 comprises a stage body 11 and a wafer holder 15. The stage body 11 comprises a first stage that is disposed on a stage base plate T, and a second stage that is disposed on the first stage. The first stage can be moved in the Y direction (anteroposterior direction) by a drive source such as a motor (not shown). The second stage can be moved in the X direction (right-and-left direction) by a drive source such as a motor (not shown). The stage body 11 can move within a horizontal plane (the XY plane) in the exposure apparatus A, according to a control signal from the CPU 3.

A movement mirror, onto which detection light is irradiated, is provided at the lateral side of the stage body 11. The reflected light from the movement mirror is detected by an interferometer 14. The position of the stage body 11 in the XY plane can be detected according to the detection light. The detected positional information of the stage body 11 is provided to the CPU 3.

The CPU 3 controls the movement of the stage body 11 based on the detected positional information of the stage body 11, and especially controls the movement between an exposure processing position P2 directly below the projection lens 24 and a wafer exchanging position P1.

As shown in FIGS. 1 to 3, the wafer holder 15, which holds a wafer W, is provided on the stage body 11. Center pins 12 (three pins in the embodiment), each of which has a rod shape and the like, are disposed on the wafer holder 15 so as to be capable of moving vertically. The center pins 12 can be moved up and down by a drive source such as a motor (not shown). Based on the control signal from the CPU 3, the center pins 12 are moved up and down, and then the wafer W mounted on the center pins 12 are lifted up and down.

The center pins 12 can move up so that the upper end portion thereof reaches a height position, which is higher than the moving plane of the loader 13. Furthermore, the center pins 12 can move down so that the upper end portion thereof reaches a lower position, which is lower than the upper surface of the wafer holder 15.

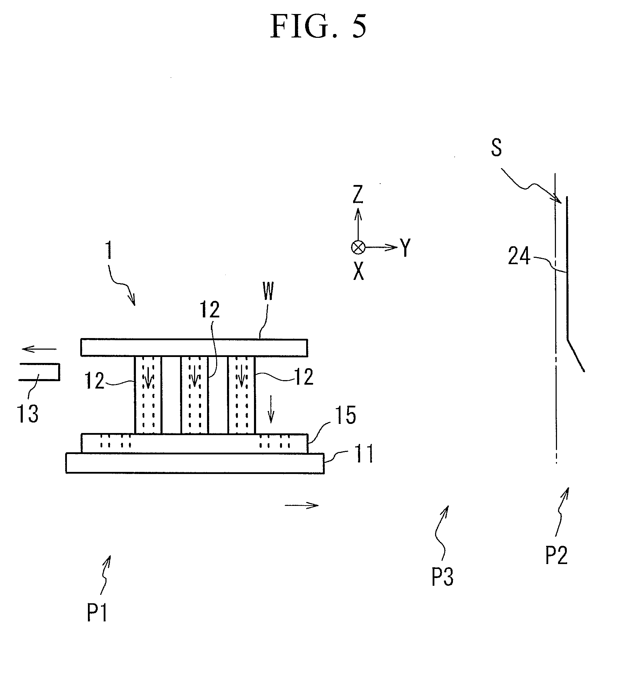

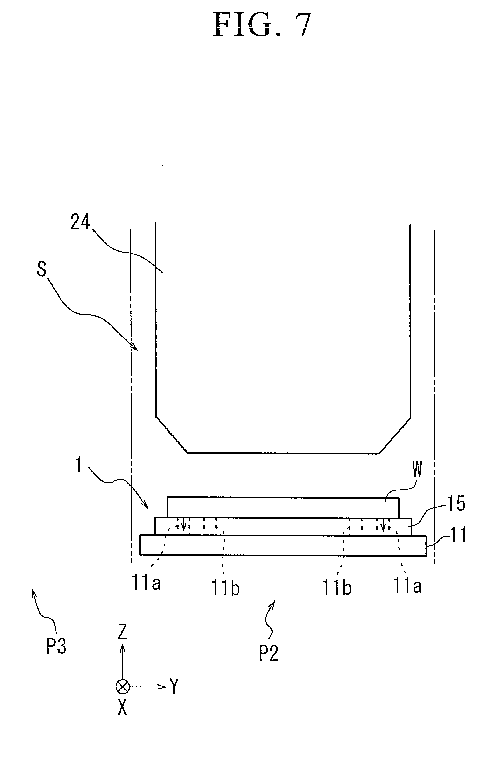

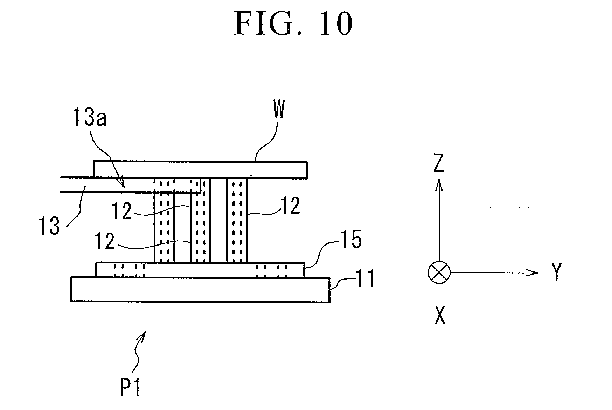

As shown in FIGS. 5 and 10, in a state where the center pins 12 are moved up, the wafer W can be transferred to and from the loader 13. Meanwhile, as shown in FIG. 7, in a state where the center pins 12 are moved down, the wafer W can be mounted on the wafer holder 15. In this manner, the wafer W is lifted up and down by means of the center pins 12, as a result, the gap (a relative positional relationship) between the wafer W and the wafer holder 15 can be adjusted.

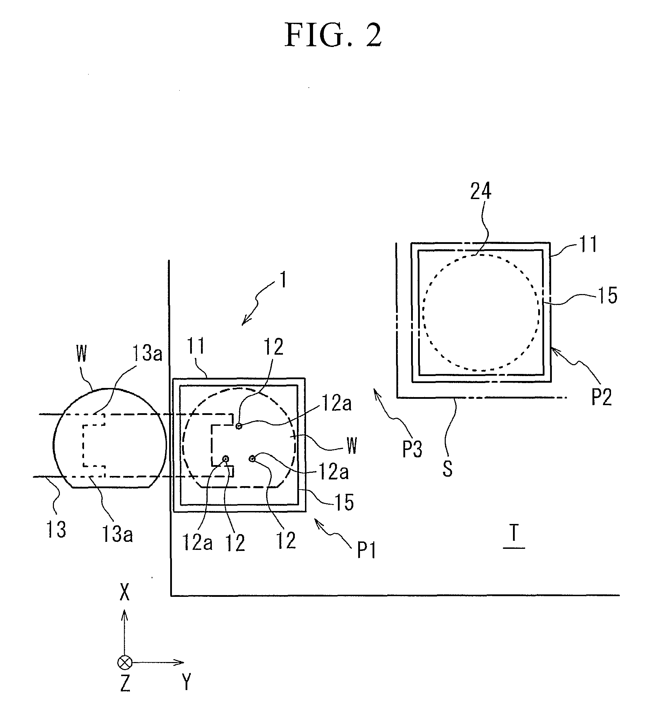

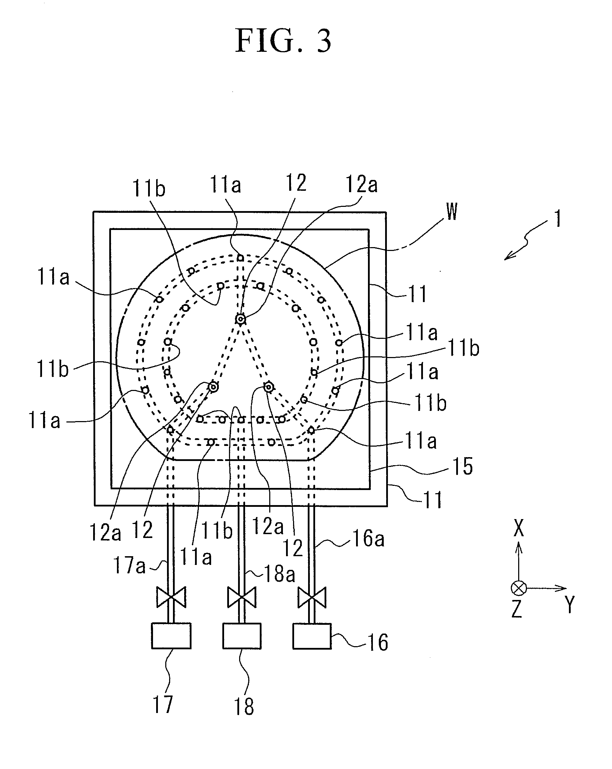

As shown in FIGS. 2 and 3, suction ports 12a are provided on the upper surfaces of the center pins 12, respectively. The suction ports 12a are in fluid communication with a suction mechanism 16 via a piping 16a. By suction operation via the suction ports 12a, the wafer W can be suctioned and held on the center pins 12. The center pins 12 can lift up and down the wafer W while suctioning and holding the wafer W.

When the wafer W is mounted on the wafer holder 15, the suction operation via the suction ports 12a is to be halted.

Furthermore, while the wafer W is moved by the loader 13 as discussed later, a pre-alignment measurement operation is executed. Based on the result of the pre-alignment measurement, the wafer W is mounted on the center pins 12 so that the center of the wafer W corresponds to the center location of the center pins 12.

Alternatively, as a substitute for the three center pins 12, a center table can be used, that has a circular wafer support member on a cylindrical lifting shaft, as disclosed in Japanese Patent Application Publication No. 2003-156322 A.

As shown in FIG. 3, a plurality of suction ports 11 a are provided on the upper surface of the wafer holder 15. The suction ports 11 a are in fluid communication with a suction mechanism 17 via a piping 17a. The center pins 12 move down to mount the wafer W on the wafer holder 15, and then the suction operation via the suction ports 11 a is executed. As a result, the wafer W is sucked to the wafer holder 15. The stage body 11 can move while suctioning and holding the wafer W (held in contact with the wafer holder 15).

In the embodiment, the suction mechanism 16 and the suction mechanism 17 are separated from each other; however, the present invention is not limited to this. For example, the suction mechanism 16 can substantially serve as the suction mechanism 17. Specifically, an electromagnetic valve can be provided between a suction mechanism and the suction ports 11 a and also between the suction apparatus and the suction ports 12a; and the switching action of the electromagnetic valves are controlled. As a result, the changeover between the suction operation with the suction mechanism 16 and the suction operation with the suction mechanism 17 can be controlled.

In the embodiment, a plurality of air supply ports 11b are provided on the wafer holder 15 and at positions different from the suction ports 11a and 12a. The air supply ports 116 are in fluid communication with a air supply apparatus 18 via a piping 18a. When the wafer W is released from the wafer holder 15, the center pins 12 move up and air is supplied from the air supply ports 11b. The air from the air supply apparatus 18 is ejected toward the lower surface (rear surface) of the wafer W via the air supply ports 11b.

Since the air is supplied toward the lower surface of the wafer W, it is possible to prevent a part of the wafer W from adhering to the wafer holder 15 and to prevent the wafer W from failing to move up. Accordingly, the wafer W can smoothly move up.

Furthermore, since the air supply ports 11b are provided at different positions from the suction ports 11a on the upper surface of the wafer holder 15, the positions of the ports 11a and 11b can be optimally set and then the suctioning and holding operation and the lifting operation for the wafer W can be smoothly executed, in comparison to the configuration in which the air supply ports 11b substantially serve as the suction ports 11a.

In the embodiment, the suction mechanism 16, the suction mechanism 17, and the air supply apparatus 18 are separated from each other; however, the suction mechanism 16, the suction mechanism 17, and the air supply apparatus 18 can be substantially unified. Specifically, the changing over among the suction operation with suction ports 11a or with suction ports 12a, the halting operation with the suction ports 12a when the wafer W is mounted on the wafer holder 15, and the air supply operation for releasing the wafer W from the wafer holder 15, can be controlled.

Next, the loader 13 will be explained. As shown in FIG. 2, the loader 13 comprises finger parts 13a that support the wafer W from below. The arm having the fingers 13a is capable of moving between the substrate housing part and the position above the wafer exchanging position P1 in the exposure apparatus A.

The loader 13 can unload the wafer W housed in the substrate housing part, transfer the wafer W to the center pins 12 at a position above the wafer exchanging position P1, and house the wafer W into the substrate housing part.

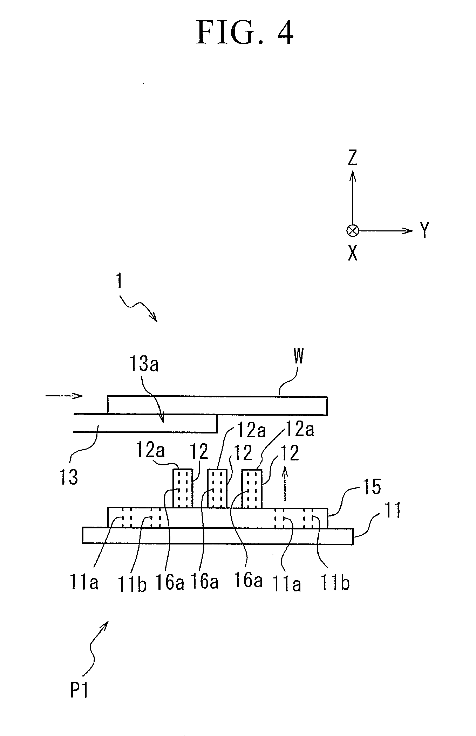

In other words, at the time of loading the wafer W, the wafer W supported on the fingers 13a of the loader 13 is loaded to the position above the wafer exchanging position P1. Then, the center pins 12 move up in order to transfer the wafer W, which has been held on the fingers 13a, is transferred to the center pins 12 (refer to FIGS. 4 and 5).

At the unloading the wafer W, the wafer W supported on the center pins 12 is lifted up to the position higher than the loader 13. That is to say, the gap between the wafer W and the wafer holder 15 broaden. The arm having fingers 13a of the loader 13 moves in (or is inserted into) the broadened gap. Then, the center pins 12 move down in order to transfer the wafer W, which has been held on the center pins 12, is transferred to the fingers 13a of the loader 13 (refer to FIG. 10).

In this manner, the exposure apparatus A adopts the above-described configurations.

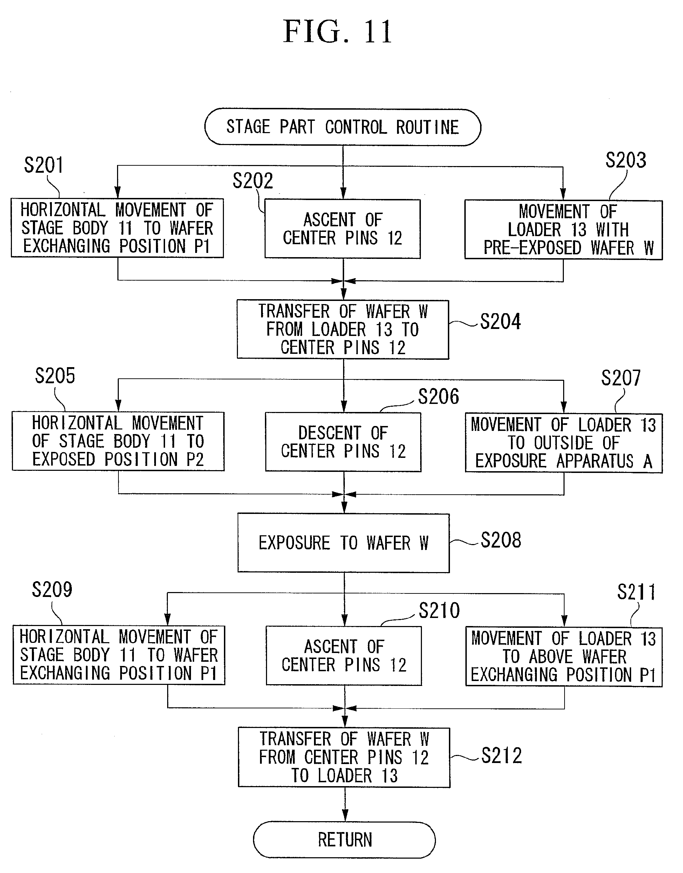

Next, the following explains the control of the wafer exchanging with the CPU 3, referencing the flow chart in FIG. 11 and appropriately referencing FIGS. 4 to 10.

### (1) Preliminary Process for Transferring a Pre-exposed Wafer

The stage body 11 is moved to the wafer exchanging position P1 (step S201), and the center pins 12 are moved up (step S202). Meanwhile, the loader 13 on which the pre-exposed wafer W is mounted is moved (step S203). In this manner, the steps S201 to S203 are simultaneously executed.

Specifically, as shown in FIG. 4, while the horizontal movement of the stage body 11 toward the wafer exchanging position P1, the center pins 12 move up to the height level where the wafer W can be transferred for the loader 13. Meanwhile, the pre-exposed wafer W, which has been housed in the substrate housing part, is loaded to the wafer exchanging position P1 in the exposure apparatus A by means of the loader 13.

At this time, after the loading of the wafer W into the wafer exchanging position P1 by the loader 13 is finished, the center pins 12 are moved up to the higher level than the level of the loader 13. Thereby, the center pins 12 are prevented from being in contact with the wafer W throughout the loading. It is noted that, at this time, the wafer W is not mounted on the wafer holder 15 of the stage body 11.

### (2) Wafer Transferring Process

The center pins 12 are moved up from the position below the wafer W that is mounted on the loader 13, thereby the wafer W is transferred from the loader 13 to the center pins 12 (step S204). At this time, the X and Y positions of the center pins 12 (the stage body 11) is preliminary positioned so that the center of the wafer W corresponds to the center location of the center pins 12, and then the wafer W is supported on the center pins 12. In addition, the wafer W is sucked onto the center pins 12 via the suction ports 12a by means of the suction mechanism 16. In this manner, the wafer W is suctioned and held on the center pins 12.

### (3) Wafer Movement Process to Exposure Processing Position

The stage body 11 is horizontally moved toward the exposure processing position P2 (step S205), and the center pins 12 are moved down (step S206). Meanwhile, the loader 13 is moved to the position outside the exposure apparatus A (step S207). In this manner, the steps S205 to S207 are simultaneously executed.

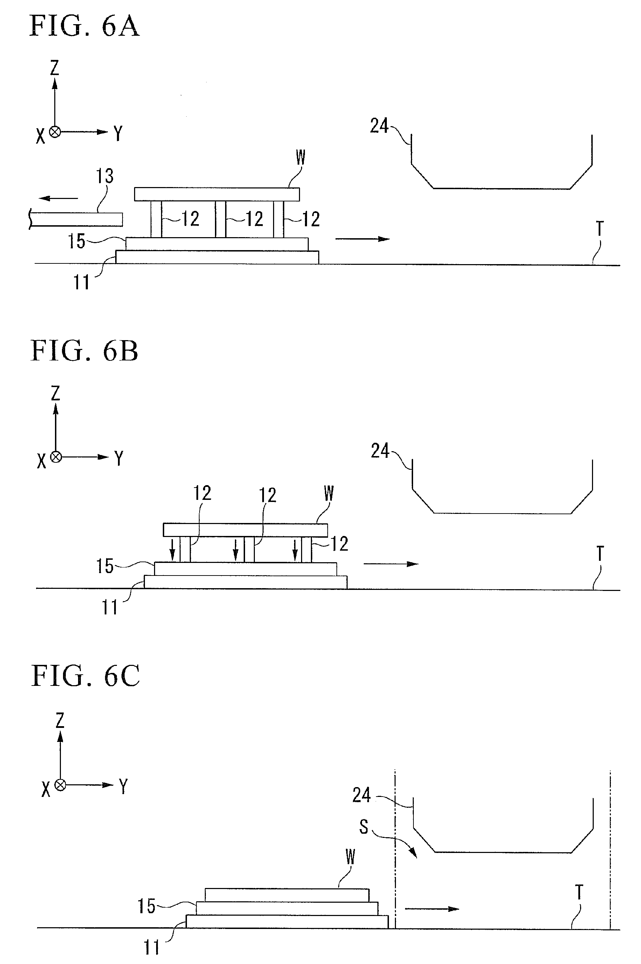

Specifically, as shown in FIGS. 5 and 6A-6C, while the horizontal movement of the stage body 11 from the wafer exchanging position P1 toward the exposure processing position P2, which is directly below the projection lens 24, the center pins 12 move down in order to mount the wafer W onto the wafer holder 15. In other words, as shown in FIG. 6B, the center pins 12 move down at the same time as the movement of the stage body 11. Meanwhile, the loader 13 is moved to the position outside the exposure apparatus A.

At this time, before the center pins 12 move down, the movement of the loader 13 to the position outside the exposure apparatus A starts. In other words, the downwardly movement of the center pins 12 will not start until the loader 13 has been moved outside the exposure apparatus A, for preventing the wafer W, which has been transferred onto the center pins 12 and is ready to move down, from being in contact with the loader 13.

Alternatively, while the stage body 11 is horizontally moved, the center pins 12 can remain undescended. In this case, for preventing the wafer W from being in contact with the loader 13, the center pins 12 will move down after the stage body 11 has been moved to the position where the wafer W will not be in contact with the loader 13 even if the wafer W moves down.

In the present embodiment, it can be controlled that the descent of the center pins 12 is substantially finished before the entry of the stage body 11 into a region S, which is peripheral to the projection lens 24. In other words, as shown in FIGS. 6B and 6C, before the entry of the stage body 11 into the region S, the center pins 12 move down so that the upper ends of the center pins 12 can move to a position lower than the upper surface of the wafer holder 15. The descent of the center pins 12 is finished, thereby the wafer W is held in contact with the wafer holder 15 and the wafer W is disposed at the minimum height position. In this manner, it is possible to prevent the wafer W from being in contact with the projection lens 24.

In the embodiment, the region S, which is above the part of the driven area of the stage apparatus 1, is set to be the peripheral region to the projection lens 24; however, the present invention is not limited to this. For example, the region S can be set as a region and as the peripheral region thereof where the contact with an autofocus system (AF) and an alignment system and the like should be avoided, and, in other words, where the wafer W may be in contact with these structures if the wafer W is lifted up. In this case, the contact with these structures can be avoided by controlling the center pins 12 not to ascend when the stage apparatus 1 is disposed in the region S.

In the embodiment, when the stage body 11 moves to a checking position P3 within the XY plane (the border area between the region S and the other region, in this embodiment), the height of the wafer W can be measured by means of a sensor not shown in the figure. Thereby, when the wafer W is not sucked to the wafer holder 15, the movement of the stage body 11 can be halted, and the completion of the descent of the center pins 12 can be waited, and then the wafer W is to be sucked to the wafer holder 15. As a result, the contact of the wafer W with the projection lens 24 and the like can be avoided.

### (4) Wafer Exposure Process

The wafer W, which has moved to the exposure processing position P2, is exposed with the pattern formed on the reticle 21 (step S208) (referring to FIG. 7).

### (5) Wafer Movement Process to Wafer Exchanging Position

The steps S209-S211 are simultaneously executed: the horizontal movement of the stage body 11 to the wafer exchanging position P1 (step S209), the ascent of the center pins 12 (step S210), and the upward movement of the loader 13 to the wafer exchanging position P1 (step S211).

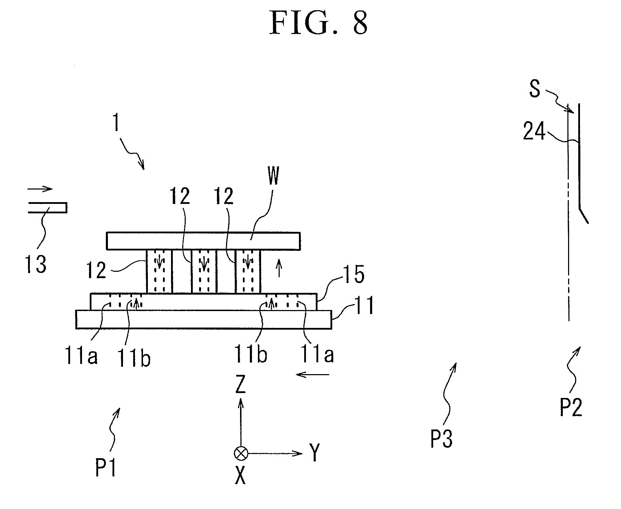

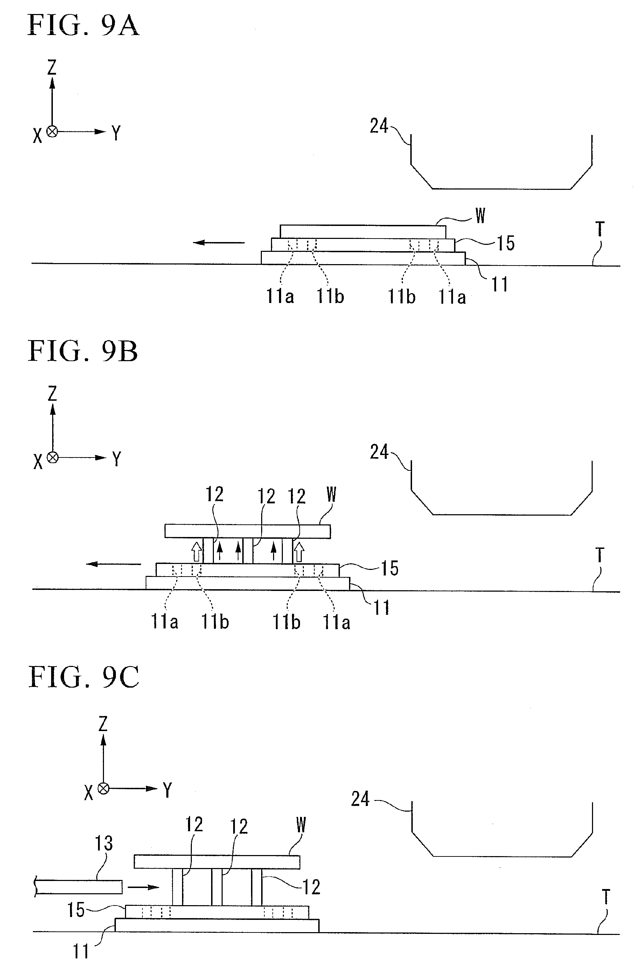

Specifically, as shown in FIG. 8 and 9A-9C, while the horizontal movement of the stage body 11 toward the wafer exchanging position P1, the center pins 12 move up to the height level where the wafer W can be transferred to the loader 13. In other words, as shown in FIG. 9B, the center pins 12 ascend at the same time as the movement of the stage body 11. Meanwhile, the loader 13 starts to upwardly move to the wafer exchanging position P1 inside the exposure apparatus A.

At this time, for preventing the contact of the ascending wafer W with the loader 13, after the lift up of the wafer W to the higher level than the loader 13 along with the ascent of the center pins 12, the loader 13 is upwardly moved toward the wafer exchanging position P1.

In the embodiment, as shown in FIG. 9B, air is supplied from the air supply ports 11b toward the lower surface (the rear surface) of the wafer W, when the stage body 11 moves and the center pins 12 move up in order to separate the wafer W from the wafer holder 15. Since the air is supplied to the lower side of the wafer W (the space between the wafer W and the wafer holder 15), it is possible to prevent a part of the wafer W adheres to the wafer holder 15 and then the wafer W fails to move up. In this manner, the movement of the stage body 11, the ascent of the center pins 12, and the supply of air to the lower surface of the wafer W are simultaneously executed. As a result, the wafer W can be moved up smoothly, while the movement of the stage body 11.

In the embodiment, the center pins 12 are controlled not to ascend when the stage body 11 is disposed within the region S. As a result, the ascent of the center pins 12 at the position below the projection lens 24 can be prevented, therefore the contact of the wafer W with the projection lens 24 can be prevented.

### (6) Post-Exposure Wafer Transferring Process

The wafer W on the center pins 12 is transferred to the loader 13 at the position above the wafer exchanging position P1 (step S212) (referring to FIG. 10). Then, the center pins 12 can receive the next pre-exposed wafer W from the loader 13.

The above-described processes (1) to (6) can be controlled to repeat.

In the embodiment, the movement operations are substantially synchronized and the operations are simultaneously executed; the operations are: the horizontal movement of the stage body 11 between the wafer exchanging position P1 and the exposure processing position P2; the upward and downward movement of the center pins 12; and the movement of the loader 13 between the inside and the outside of the exposure apparatus A. However, the present invention is not limited to this. Alternatively, the start times and/or the finish times of the operations can be shifted from each other; the operations are: the horizontal movement of the stage body 11; the upward and downward movement of the center pins 12; and the movement of the loader 13 between the inside and the outside of the exposure apparatus A. Furthermore, any two operations can be combined and simultaneously executed, among the horizontal movement of the stage body 11; the upward and downward movement of the center pins 12; and the movement of the loader 13 between the inside and the outside of the exposure apparatus A.

In the embodiment, the gap between the wafer W and the wafer holder 15 is adjusted by upward and downward movement of the center pins 12. However, the present invention is not limited to this. Alternatively, by fixing the center pins 12 and upwardly and downwardly moving the wafer holder 15, the gap between the wafer W and the wafer holder 15 can also be adjusted. In addition, by moving the center pins 12 and upwardly and downwardly moving the wafer holder 15, the gap between the wafer W and the wafer holder 15 can also be adjusted.

In the embodiment, the transfer section according to the present invention is applied to the exposure apparatus provided for a process in the lithography processing. However, the present invention is not limited to this. It can be widely applied to various apparatuses in which a substrate is moved by means of a transfer section.

As the substrate in the embodiments, in addition to a semiconductor wafer for semiconductor device manufacture, a glass substrate for a display device, a ceramic wafer for a thin film magnetic head, a master mask or reticle (synthetic quartz, silicon wafer) for use in an exposure apparatus, a film member or similar may be employed. The substrate is not limited to circular shape; rectangular or other shapes can be used.

In the embodiments, positional information about the mask stage and the substrate stage are each measured using an interferometer system, but the present invention is not limited thereto and, for example, an encoder system may be used that detects a scale (diffraction grating) that is provided to the upper surface of the substrate stage. In this case, it is preferable to adopt a hybrid system that is provided with both an interferometer system and an encoder system, and to use the measurement results of the interferometer system to calibrate the measurement results of the encoder system. In addition, the position of the substrate stage may be controlled by switching between the interferometer system and the encoder system, or by using both.

Moreover, the exposure apparatus in the embodiments can comprise a substrate stage for holding a substrate, and a measurement stage on which is mounted a reference member formed with a reference mark, and/or various photoelectronic sensors, as disclosed for example in Japanese Patent Application, Publication No. H11-135400 A (corresponding to PCT International Patent Publication No. WO 1999/23692), and Japanese Patent Application, Publication No. 2000-164504 A (corresponding to U.S. Patent No. 6,897,963).

In the embodiments, the mask is used for forming the pattern. Alternatively, electronic mask that generates variable patterns (also called variable pattern forming mask, active mask or pattern generator) may be used. For example, a deformable micro-mirror device or digital micro-mirror device (DMD), which is a kind of non-radiative type image display element (also called spatial light modulator (SLM)) may be used as the electronic mask. The DMD has a plurality of reflecting elements (micro-mirrors) that are driven based on specified electronic data. The plurality of reflecting elements are arranged in a two-dimensional matrix form on the surface of the DMD, are driven in element units, and they reflect and deflect the exposure light. The operation of the DMD is controlled by the control apparatus. The control apparatus drives the reflecting elements of each DMD and forms patterns of the exposure light shone by the illumination system using the reflecting elements, based on the electronic data (pattern information) corresponding to the pattern to be formed on the substrate. By using DMD, mask alignment operations in the mask stage and during the mask replacement work are not required when the pattern is changed, in contrast to the case when exposure is performed using mask (reticle) on which pattern is formed. A mask stage is not installed in an exposure apparatus using electronic mask; the substrate may merely be moved in the X-axis and the Y-axis directions by the substrate stage. The exposure apparatus using DMD is disclosed, for example, in Japanese Patent Application, Publication No. H08-313 842 A, Japanese Patent Application, Publication No. 2004-304135 A, and U.S. Patent No. 6,778,257.

Furthermore, the present invention can also be applied to a multistage type exposure apparatus provided with a plurality of substrate stages as disclosed for example in Japanese Patent Application, Publication Nos. 10-163099 and 10-214783, and Published Japanese translation No. 2000-505958 of PCT International Publication or the like.

As far as is permitted, the disclosures in all of the Publications and U.S. Patents related to exposure apparatuses and the like cited in the above respective embodiments and modified examples, are incorporated herein by reference.

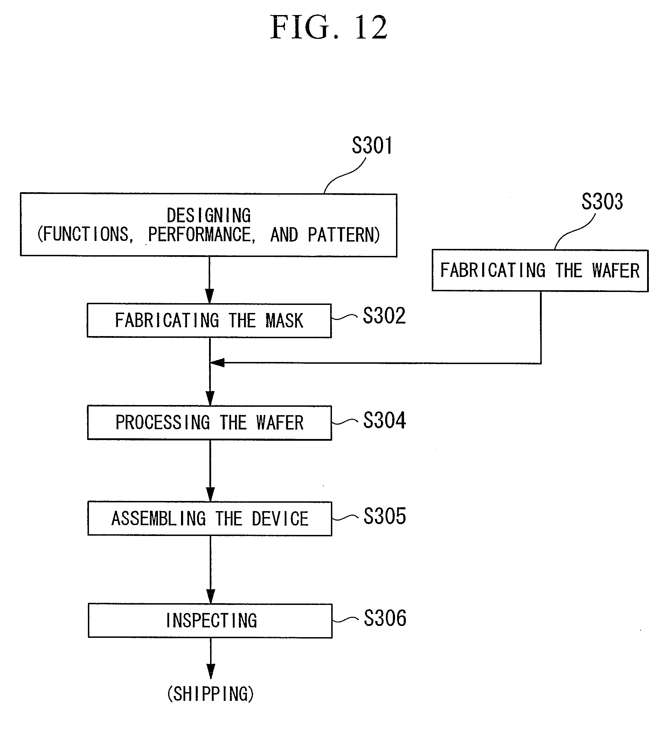

As shown in FIG. 12, microdevices such as semiconductor devices are manufactured by going through; a step 301 that performs microdevice function and performance design, a step 302 that fabricates the reticle 21 based on this design step, a step 303 that manufactures the wafer W made from silicon material, a step 304 including substrate processing steps such as a process that exposes the pattern on the reticle 21 onto the wafer W by means of the exposure apparatus A of the aforementioned embodiments, a process for developing the exposed substrate, and a process for heating (curing) and etching the developed substrate, a device assembly step (including treatment processes such as a dicing process, a bonding process and a packaging process) 305, and an inspection step 306, and so on.

Furthermore, the transfer section (stage apparatus) of the abovementioned embodiments is not limited in its application to processes of fabricating semiconductor devices. For example, it can be adapted widely to processes for fabricating display apparatuses, such as plasma displays or liquid crystal display devices that are formed in an angular glass plate, as well as to processes for fabricating various devices such as image capturing devices (CCDs and the like), micromachines, thin film magnetic heads, and DNA chips. Furthermore, the present invention can also be adapted to fabrication processes that are employed when photolithography is used to fabricate a reticle (a photomask, and the like) wherein a reticle pattern of various devices is formed.

## Claims

1. A stage apparatus comprising:
a mover movable between a first position and a second position and having a holding part that holds a substrate, the substrate being held by the holding part at the first position and being released from the holding part at the second position;
a first mechanism that adjusts a gap between the substrate and the holding part; and
a control apparatus that simultaneously executes the movement of the mover between the first position and the second position and at least a part of the adjustment of the gap by the first mechanism.

2. The stage apparatus according to claim 1, wherein the control apparatus controls the adjustment of the gap by the first mechanism within a predetermined moving range of the mover.

3. The stage apparatus according to claim 1 or 2, wherein the first mechanism comprises a second mechanism that is provided on the mover and can lift the substrate.

4. The stage apparatus according to claim 3, further comprising a third mechanism that loads or unloads the substrate to or from the second position, wherein
the control apparatus simultaneously executes the loading or the unloading of the substrate by the third mechanism, the movement of the mover between the first position and the second position, and at least a part of the lift of the substrate by the second mechanism.

5. The stage apparatus according to claim 3 or 4, further comprising a fourth mechanism that supplies a gas from the mover toward the substrate along with the lift of the substrate.

6. The stage apparatus according to any one of claims 3 to 5, further comprising a fifth mechanism that has a suction port and causes the substrate to adhere to the mover, the suction port disposed at a different position from a position at which the gas is blown out by the fourth mechanism.

7. An exposure apparatus that positions a substrate at an exposed position by use of the stage apparatus according to any one of claims 1 to 6, and that executes an exposure process to the substrate at the exposed position.

8. A stage control method comprising:
moving a substrate between a first position and a second position, the substrate being held by a holding part at the first position and being released from the holding part at the second position; and
adjusting a gap between the substrate and the holding part, at least a part of the adjustment being executed along with the movement of the substrate.

9. The stage control method according to claim 8, wherein the adjustment of the gap is executed within a predetermined moving range of the substrate.

10. The stage control method according to claim 8 or 9, wherein the adjustment of the gap comprises lifting the substrate.

11. The stage control method according to any one of claims 8 to 10, further comprising loading or unloading the substrate to or from the second position, wherein the loading or the unloading is executed along with the movement of the substrate and with at least a part of the adjustment of the gap.

12. The stage apparatus according to claim 10 or 11, further comprising supplying a gas toward the substrate along with the lift of the substrate.

13. A stage apparatus comprising:
a mover movable between a first position and a second position and having a holding part that holds a substrate, the substrate being held by the holding part at the first position and being released from the holding part at the second position; and
a second mechanism that supplies a gas toward the substrate, the supply of the gas being executed along with at least a part of the movement of the mover between the first position and the second position.

14. A stage control method comprising:
moving a substrate between a first position and a second position, the substrate being held by a holding part at the first position and being released form the holding part at the second position; and
supplying a gas toward the substrate, wherein at least a part of the supply of the gas is executed along with the movement of the substrate.

15. An exposure method comprising:
controlling a stage by use of the stage control method according to any one of claims 8 to 12, and 14; and
positioning the substrate at an exposed position and executing an exposure process to the substrate at the exposed position.

16. A device fabricating method that comprises a control step in which a stage is controlled by use of the stage control method according to any one of claims 8 to 12, and 14.
